Europäisches Patentamt

European Patent Office

Office européen des brevets

(11) Numéro de publication: **0 214 350**
**B1**

---

(12) **FASCICULE DE BREVET EUROPEEN**

---

(45) Date de publication du fascicule du brevet:
**23.05.90**

(21) Numéro de dépôt: **85401528.6**

(22) Date de dépôt: **24.07.85**

(51) Int. Cl.⁵: **C30B 13/02, C30B 29/48**

---

(54) Procédé de préparation d'un alliage polycristallin destiné à la réalisation de monocristaux par passage dans une zone de solvant.

---

(43) Date de publication de la demande:
**18.03.87 Bulletin 87/12**

(45) Mention de la délivrance du brevet:
**23.05.90 Bulletin 90/21**

(84) Etats contractants désignés:
**DE GB**

(56) Documents cités:
**FR-A- 2 560 226**
**GB-A- 2 051 607**
**US-A- 3 849 205**

(73) Titulaire: **COMMISSARIAT A L'ENERGIE ATOMIQUE, 31/33, rue de la Fédération, F-75015 Paris(FR)**

(72) Inventeur: **Fillot, Alain, Chemin des Ratz Les Eymes, F-38330 Saint Ismier(FR)**
Inventeur: **Gallet, Jean, Le Babolui Miribel Les Echelles, F-38380 Saint Laurent Du Var(FR)**
Inventeur: **Paltrier, Sylvain, 49Bis, rue des Ayguinards, F-38240 Meylan(FR)**
Inventeur: **Schaub, Bernard, 30, rue Gay Lussac, F-38100 Grenoble(FR)**

(74) Mandataire: **Mongrédien, André et al, c/o BREVATOME 25, rue de Ponthieu, F-75008 Paris(FR)**

---

ACTORUM AG

## Description

L'invention concerne l'élaboration d'un alliage polycristallin ternaire ou quaternaire destiné à la fabrication de composés semiconducteurs par passage de façon connue dans une zone de solvant; de façon plus précise, l'invention concerne la réalisation de l'alliage "source" qui est destiné, par passage dans la zone de solvant, à fournir des cristaux de composés semiconducteurs soit ternaires du type $Cd_x Hg_{0,5-x} Te_{0,5}$, soit quaternaires du type $Cd_x Hg_{0,5-x} Te_y Se_{0,5-y}$, dans lesquels $0 < x < 0,5$ et $0 < y < 0,5$. Ces composés présentent une largeur de bande interdite qui varie de façon continue avec les fractions atomiques x et y, ce qui autorise ainsi la fabrication de photodétecteurs infrarouges à toute longueur d'onde supérieure à 0,8 micromètre.

D'un point de vue général, l'utilisation d'un solvant permet l'élaboration de tels composés semiconducteurs à une température inférieure à leur température de fusion et par conséquent d'obtenir des matériaux plus purs et de meilleure qualité cristalline. D'un point de vue plus particulier, l'utilisation d'un solvant dans le cas de composés semiconducteurs $Cd_x Hg_{0,5-x} Te_{0,5}$ et $Cd_x Hg_{0,5-x} Te_y Se_{0,5-y}$ permet de s'affranchir en outre des difficultés liées au fait que la vapeur de mercure a une pression élevée aux températures de fusion desdits composés.

Le principe général de la méthode de formation d'un monocristal par transfert de solvant, consiste à faire traverser longitudinalement un lingot d'un composé semiconducteur solide par une zone fondue de ce solvant. Cette méthode est largement connue et a fait l'objet entre autre des brevets français FR-A 2 295 792 du 24.12.1974 et FR-A 2 536 767 du 30.11.1982 déposés au nom du COMMISSARIAT A L'ENERGIE ATOMIQUE.

Le brevet français BF-A 2 295 792 l'utilisation de barres d'alliage juxtaposées comme matériaux constituant la "source" d'alimentation de la zone de solvant pour la croissance de composés semiconducteurs du type II–VI; le brevet français FR-A 2 502 190 de la société anonyme de télécommunications associe l'opération de juxtaposition de barres de CdTe et HgTe avec l'utilisation d'une zone de solvant initial constitué d'un mélange CdHgTe riche en tellure. Dans ce cas, l'utilisation d'une barre de HgTe implique une limitation de la température de la zone de solvant qui ne doit pas dépasser 760°C, qui est la température de fusion de l'alliage HgTe.

Dans le brevet français FR-A 2 536 767, on propose une méthode dans laquelle, le matériau d'alimentation ou "source" de la zone de solvant, est un mélange homogène compacté et interdiffusé de poudre de CdTe et de HgTe. Ceci permet d'éviter l'usinage délicat des barres d'alliage autrement nécessaires pour obtenir les proportions exactes voulues et permet de s'affranchir de la solubilité préférentielle de HgTe dans le solvant. Cette méthode permet également d'effectuer le transfert au travers de la zone de solvant à des températures supérieures à 670°C, mais la porosité résiduelle du matériau source reste un handicap pour la réalisation de cristaux de grande longueur.

D'une façon générale, on voit que les divers procédés de l'art antérieur posent des problèmes importants à l'homme de l'art dans la préparation des cristaux ternaires ou quaternaires $Cd_x Hg_{0,5-x} Te_{0,5}$ ou $Cd_x Hg_{0,5-x} Te_y Se_{0,5-y}$ lorsqu'on emploie la méthode de transfert d'un alliage source dans une zone de solvant.

En effet, la préparation d'un alliage source de grande homogénéité de composition et exempt de porosités est relativement délicate.

On a déjà réalisé des alliages ternaires ou quaternaires en chauffant jusqu'à fusion les composés dans une ampoule scellée par un bouchon prolongé ou non par un tube capillaire, cette ampoule étant disposée dans une enceinte permettant d'élever la température de l'alliage en cours de formation en plaçant cette enceinte dans un four électrique et en maintenant à son intérieur, c'est-à-dire autour de l'ampoule, une pression élevée d'un gaz neutre ou réducteur de façon à compenser la pression de la vapeur de mercure en équilibre avec le liquide pour l'empêcher de s'échapper de l'ampoule ou à obtenir que les parois minces de cette dernière ne soient pas soumises à une différence de pression significative entre l'intérieur et l'extérieur.

Ces techniques ont été décrites dans divers articles de J. STEININGER, par exemple, paru en 1977 dans le Journal of Crystal Growth, volume 37, pages 107–115, et de A.W. VERE et al. paru en 1982 dans le Journal of Crystal Growth, volume 59, pages 121 à 129, mais conduisent à des lingots d'homogénéité insuffisante pour la croissance d'un cristal, par passage d'une zone de solvant.

On peut encore citer le document GB-A 2 051 607 relatif à a préparation de monocristaux de matériaux ternaires, notamment des compositions CdHgTe par une méthode consistant à fondre les composants ensemble, à tremper le mélange pour produire un lingot polycristallin puis à produire un monocristal à partir de ce lingot par la méthode de fusion de zone. Ce document complète l'art antérieur précédemment décrit.

La présente invention a précisément pour objet un procédé d'un alliage source polycristallin qui échappe aux inconvénients de l'art antérieur cité, tout en étant d'une mise en œuvre au moins aussi simple que les procédés de cet art antérieur.

Dans ce procédé de préparation d'un alliage polycristallin ternaire ou quaternaire, destiné à la réalisation de monocristaux par passage de façon connue dans une zone de solvant, les constituants de l'alliage sont placés en proportion voulue dans une ampoule à parois minces placée dans une enceinte remplie d'un gaz à pression élevée et munie de moyens de chauffage et de refroidissement rapide, des moyens de mesure de la température sont disposés au voisinage des constituants à traiter, on réalise la fusion totale du composé de composition voulue en le chauffant à une température supérieure à son point de fusion et pendant une durée suffisante à l'homogénéisation du liquide, puis on réalise un refroidissement progressif et isotherme de ce liquide en l'amenant à une température inférieure à sa température de fusion et en surveillant, à l'aide des moyens de mesure de la température, la remontée brusque de celle-ci annonçant la fin de la surfusion du liquide, et l'on opère alors une trempe brutale du mélange provoquant ainsi la solidification instantanée de l'ensemble sous forme d'un lingot polycristallin homogène.

Le chauffage pendant au moins une heure, suffit à réaliser une très bonne homogénéisation du liquide et l'abaissement lent et contrôlé de la température permet d'assurer le refroidissement isotherme du liquide jusqu'à l'obtention de l'état de surfusion. Il est bien connu de l'homme de l'art que ce phénomène de surfusion présente un caractère aléatoire, c'est-à-dire que pour un même liquide et toute condition identique par ailleurs, la solidification brutale peut intervenir à des températures très différentes d'une expérience à l'autre. C'est pourquoi dans le procédé selon l'invention, le capteur de température peut être disposé contre l'ampoule généralement un thermocouple et surveille l'apparition d'une remontée brusque de celle-ci, caractéristique du changement d'état consécutif au début de la solidification et permet ainsi de mettre en route la trempe par refroidissement rapide au moment ultime où cesse la surfusion du liquide. La cristallisation est alors instantanée en tout point du milieu et elle intervient sous forme homogène en température, ce qui conduit à l'obtention d'un lingot polycristallin d'homogénéité très grande. Dans ces conditions de mise en oeuvre du procédé, la ségrégation du cadmium et du mercure, qui est physiquement inévitable, ne s'opère par conséquent qu'à très courte distance.

Selon une caractéristique secondaire du procédé objet de l'invention, la fusion totale du composé est réalisée à une température supérieure de 50°C environ à sa température de fusion et, le refroidissement progressif ultérieur a lieu à un taux voisin de 20°C par heure.

Selon une autre caractéristique du procédé objet de l'invention, la trempe brutale de l'ampoule est réalisée, après arrêt des moyens de chauffage de l'enceinte, par une circulation d'un gaz froid autour de l'ampoule. De préférence, on utilise un gaz neutre comme l'hélium, l'azote, l'argon et plus particulièrement l'hélium; on pourrait aussi faire appel à un gaz réducteur comme l'hydrogène pur par exemple.

L'opération de trempe à l'aide d'un gaz froid autour de l'ampoule est grandement favorisée par la faible épaisseur des parois de l'ampoule, généralement en silice, qui dans ces conditions, ne sont plus un obstacle aux échanges de chaleur importants et rapides.

La mise en oeuvre du procédé objet de l'invention, permet par conséquent d'obtenir un lingot de composé ternaire ou quaternaire polycristallin, notamment de formule $Cd_x Hg_{0,5-x} Te_{0,5}$ ou $Cd_x Hg_{0,5-x} Te_y Se_{0,5-y}$ de grande homogénéité de composition et sans aucune porosité, par conséquent tout à fait apte à être traversé par une zone de solvant pour la fabrication d'un monocristal, par exemple de corps semiconducteur.

De toute façon, l'invention sera mieux comprise à la lecture de la description qui suit d'un exemple donné à titre illustratif et non limitatif de mise en oeuvre du procédé objet de l'invention.

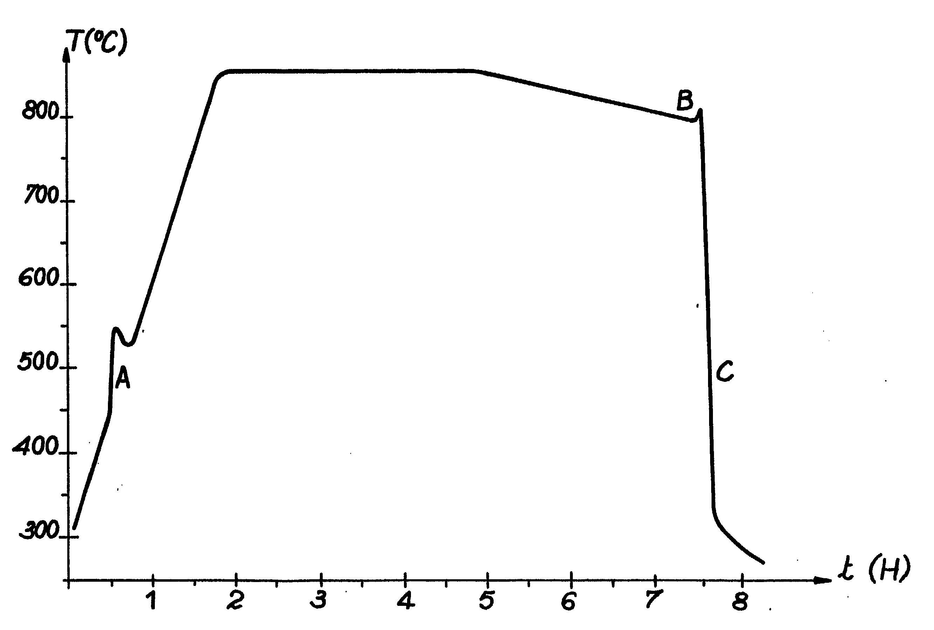

Sur la figure 1, on a représenté l'évolution de la température pendant les phases du procédé.

Dans l'exemple de mise en oeuvre de l'invention, que l'on va décrire maintenant, on réalise la préparation d'un alliage liquide ternaire ou quaternaire de formule $Cd_x Hg_{0,5-x} Te_{0,5}$ ou $Cd_x Hg_{0,5-x} Te_y Se_{0,5-y}$ de composition souhaitée, étant entendu que la souplesse du procédé permet la réalisation de toute composition déterminée à l'avance.

On commence d'abord par mettre dans une ampoule à paroi mince, par exemple en silice, les éléments constitutifs, soit sous forme des composés CdTe, HgTe, CdTeSe, etc..., soit sous forme d'éléments simples eux-mêmes, tels que Cd, Hg, Te, Se.

L'ampoule est alors ici scellée à l'aide d'un bouchon prolongé d'un tube capillaire ouvert et l'ensemble est disposé dans une enceinte entourée d'un four permettant d'élever la température de la charge au-delà du point de fusion total du composé ternaire ou quaternaire que l'on veut réaliser. Cette enceinte est conçue en outre pour maintenir autour de l'ampoule une pression élevée de gaz neutre ou réducteur. Ceci permet d'éviter que la vapeur de mercure en équilibre avec le liquide au moment du chauffage ne s'échappe de l'ampoule et également que les parois minces de cette dernière ne soient soumises à une différence de pression notable entre l'intérieur et l'extérieur de l'ampoule. La pression de gaz neutre ou réducteur n'a pas à être déterminée avec précision, mais doit simplement être supérieure à la pression de vapeur de mercure en équilibre thermodynamique avec le liquide. Cette pression de vapeur, différente pour chaque composition du liquide, est bien connue de par la littérature existante (R.F. BEBRICK, Journal of Vacuum Science Technology, 21 (1), mai-juin 1982).

Selon le procédé, objet de l'invention, un capteur de température, généralement un thermocouple, est disposé contre l'ampoule et permet de suivre l'évolution de la température du liquide que celle-ci renferme. Cette température est établie à une valeur supérieure à la température de fusion totale $T_F$, de la phase liquide, couramment par exemple à 50°C au-dessus de celle-ci. La température de fusion totale des composés, différente en fonction de chaque composition est également bien connue de par la littérature antérieure (F.R. SFOFAN et S.L. LEHOCZKY, Journal of Electronic Material, vol. 10, n° 6, 1981).

Après quelques heures nécessaires à l'homogénéisation du liquide, la température de l'ampoule est abaissée progressivement, par exemple de 20°C par heure. Cette vitesse de descente de la température n'a d'ailleurs pas à être établie avec une grande précision, la seule condition à réaliser étant qu'elle assure un refroidissement isotherme du liquide. Cette phase du procédé permet ainsi d'amener le mélange liquide homogène à une température inférieure à la température de début de solidification, c'est-à-dire à provoquer le phénomène de surfusion. On surveille alors à l'aide du capteur de température disposé contre l'ampoule, la remontée brusque de cette température caractéristique de l'apparition des calories engendrées par le début de la solidification. Dès cet instant, on opère alors un refroidissement rapide ou trempe de l'ampoule à l'ultime instant de la surfusion du liquide. De cette façon, le liquide qui est homogène en température cristallise instantanément en tous points au même instant, tandis que la ségrégation inévitable du cadmium et du mercure ne s'opère qu'à une très courte distance. La réalisation de la trempe est assurée à l'aide de moyens classiques en métallurgie à savoir la suppression de l'alimentation électrique du four de chauffage et l'injection simultanée de gaz froid autour de l'ampoule, ce gaz pouvant être notamment de l'hélium dont la conductibilité thermique est élevée. L'opération de trempe est grandement favorisée par la faible épaisseur des parois de l'ampoule qui ne sont plus alors un obstacle aux échanges de chaleur entre la phase liquide en cours de cristallisation et l'extérieur.

La mise en oeuvre du procédé qui vient d'être décrit d'une façon générale a permis la réalisation de lingots de composés ternaires du type $Cd_x\ Hg_{0,5-x}\ Te_{0,5}$ ou quaternaires du type $Cd_x\ Hg_{0,5-x}\ Te_y\ Se_{0,5-y}$ avec $(x, y < 0,5)$ sous forme polycristalline et possédant une grande homogénéité de composition tout en étant dénuée de toute porosité. Ces composés sont parfaitement adaptés à être ensuite traités au travers d'une zone de solvant pour réaliser la préparation de monocristaux de corps semiconducteurs composés utilisables notamment comme détecteurs infrarouges.

En se référant à la figure 1, on décrit ci-après un exemple précis de réalisation d'un lingot d'alliage polycristallin.

L'exemple de réalisation expérimentale suivant illustre la mise en oeuvre du procédé pour la fabrication d'un lingot ternaire de composition particulière $Cd_{0,11}\ Hg_{0,39}\ Te_{0,5}$.

Dans une ampoule en silice à parois minces de diamètre intérieur de 24 mm et extérieur de 28 mm, sont disposés 24,69 g de Cd, 127,40 g de Te et 156,31 g de Hg, tous produits de haute pureté. L'ampoule est ici fermée par scellement d'un bouchon de silice prolongé d'un tube capillaire de diamètre intérieur de 5 mm et d'environ 200 mm de longueur. Un thermocouple étant fixé à la paroi extérieure de l'ampoule celle-ci est disposée dans la zone isotherme d'un four haute pression. L'enceinte du four est alors évacuée et remplie plusieurs fois d'hélium de haute pureté et finalement pressurisée avec ce gaz jusqu'à 50 atmosphères.

La température est alors élevée à 850°C en deux heures environ, la température théorique de fusion totale du mélange étant de 804°C. La pression est alors ajustée à environ 70 atmosphères. L'enregistrement du signal du thermocouple, présenté figure 1, permet de constater, région A, l'élévation de température vers 450°C due aux calories générées par la réaction des éléments constitutifs.

Après trois heures à 850°C, la température est abaissée à un taux d'environ 20°C par heure, l'ampoule étant isotherme. A 791°C, soit une surfusion ultime de 13°C, l'enregistrement fait apparaître (région B, figure 1) une brusque remontée de la température liée aux calories générées, en tous points du liquide, par le début de cristallisation. L'alimentation électrique du four est alors immédiatement supprimée, tandis que l'on fait circuler autour de l'ampoule un courant d'hélium froid de 30 m³/h, la pression dans l'enceinte étant maintenue (figure 1, région C).

Après refroidissement complet, l'enceinte est ramenée à la pression atmosphérique, l'ampoule est ouverte par sciage et livre un lingot polycristallin à grains fins de quelques mm³, sans porosité, de composition atomique homogène $Cd_{0,11}\ Hg_{0,39}\ Te_{0,5}$, apte à la cristallisation d'un monocristal semiconducteur de même composition par passage d'une zone de solvant.

**Revendications**

1. Procédé de préparation d'un alliage polycristallin, ternaire ou quaternaire destiné à la réalisation de monocristaux par passage de façon connue dans une zone de solvant, procédé dans lequel les constituants de l'alliage sont placés en proportion voulue dans une ampoule à parois minces, placée dans une enceinte remplie d'un gaz à pression élevée et munie de moyens de chauffage et de refroidissement rapide, des moyens de mesure de la température sont disposés au voisinage des constituants à traiter, après quoi on réalise la fusion totale du composé de composition voulue en le chauffant à une température supérieure à son point de fusion et pendant une durée suffisante à l'homogénéisation du liquide, puis on réalise un refroidissement progressif et isotherme de ce liquide en l'amenant à une température inférieure à sa température de fusion et en surveillant, à l'aide de moyens de mesure de la température, la remontée brusque de celle-ci annonçant la fin de la surfusion du liquide, et l'on opère alors une trempe brutale du mélange provoquant ainsi la solidification instantanée de l'ensemble sous forme d'un lingot polycristallin homogène.

2. Procédé selon la revendication 1, caractérisé en ce que le composé est porté à une température supérieure de 50°C environ à sa température de fusion et en ce que le refroidissement progressif ultérieur a lieu à un taux voisin de 20°C par heure.

3. Procédé selon la revendication 1, caractérisé en ce que la durée du maintien de température est au moins égale à une heure.

4. Procédé selon l'une quelconque des revendications 1 à 3, caractérisé en ce que la trempe brutale de l'ampoule est réalisée, après arrêt des moyens de chauffage de l'enceinte par une circulation d'un gaz froid autour de l'ampoule.

5. Procédé selon la revendication 4, caractérisé en ce que le gaz est neutre et choisi dans le groupe de l'hélium, l'argon, l'azote.

6. Procédé selon la revendication 4, caractérisé en ce que le gaz est de l'hydrogène sec.

7. Application du procédé selon l'une quelconque des revendications 1 à 6 précédentes à la préparation d'un alliage polycristallin choisi dans le groupe comprenant les alliages ternaires $Cd_x\ Hg_{0,5-x}\ Te_{0,5}$

et les alliages quaternaires $Cd_x Hg_{0,5-x} Te_y Se_{0,5-y}$, formules dans lesquelles $0 < x < 0,5$ et $0 < y < 0,5$.

**Claims**

1. Process for the preparation of a ternary or quaternary polycrystalline alloy for producing monocrystals by passing in per se known manner into a solvent zone, the components of the alloy being placed in a desired proportion in a thin-walled ampoule placed in an enclosure filled with a gas at high pressure and equipped with fast heating and cooling means, means for measuring the temperature being positioned in the vicinity of the components to be treated, the compound of desired composition is completely melted by heating to a temperature above its melting point and for a time sufficient for the homogenization of the liquid, followed by a progressive, isothermic cooling of said liquid by bringing it to a temperature below its melting point and monitoring, with the aid of a temperature measuring means, the sudden rise thereof indicating the end of the superfusion of the liquid, followed by a sudden tempering of the mixture bringing about the instantaneous solidification in the form of a homogenous polycrystalline ingot.

2. Process according to claim 1, characterized in that the compound is raised to a temperature approximately 50°C higher than its melting point and wherein the subsequent progressive cooling takes place at a rate of about 20°C per hour.

3. Process according to claim 1, characterized in that the temperature maintenance time is at least equal to one hour.

4. Process according to any one of the claims 1 to 3, characterized in that the sudden tempering of the ampoule is carried out, following the stoppage of the enclosure heating means, by a cold gas circulation around the ampoule.

5. Process according to claim 4, characterized in that the gas is neutral and chosen from the group helium, argon and nitrogen.

6. Process according to claim 4, characterized in that the gas is dry hydrogen.

7. Application of the process according to any one of the claims 1 to 6, to the preparation of a polycrystalline alloy chosen from the group including the ternary alloys $Cd_x Hg_{0.5-x} Te_{0.5}$ and the quaternary alloys $Cd_x Hg_{0.5-x} Te_y Se_{0.5-y}$.

**Patentansprüche**

1. Verfahren zur Herstellung einer ternären oder quaternären polykristallinen Legierung, die bestimmt ist für die Herstellung von Einkristallen durch an sich bekannte Einführung in eine Lösungsmittelzone, bei dem die Bestandteile der Legierung in dem gewünschten Mengenverhältnis in eine dünnwandige Ampulle eingeführt werden, die in einem Behälter angeordnet wird, der mit einem unter erhöhtem Druck stehenden Gas gefüllt und mit Einrichtungen zum schnellen Erwärmen und Abkühlen ausgestattet ist und in dem Einrichtungen zur Messung der Temperatur in der Nähe der zu behandelnden Bestandteile angeordnet sind, wonach die gesamte Verbindungszusammensetzung aufgeschmolzen wird durch Erwärmen derselben auf eine Temperatur oberhalb ihres Schmelzpunktes und für eine Zeitspanne, die ausreicht, um die Flüssigkeit zu homogenisieren, dann diese Flüssigkeit progressiv und isotherm abgekühlt wird, indem man sie auf eine Temperatur unterhalb ihres Schmelzpunktes bringt und mittels einer Temperaturmeßeinrichtung den schnellen Wiederanstieg der Temperatur überwacht, der das Ende der Überschmelzung der Flüssigkeit anzeigt, und danach die Mischung brutal abschreckt, um so die sofortige Erstarrung derselben in Form eines homogenen polykristallinen Blockes zu bewirken.

2. Verfahren nach Anspruch 1, dadurch gekennzeichnet, daß die Zusammensetzung auf eine Temperatur gebracht wird, die um etwa 50°C über ihrer Schmelztemperatur liegt, und daß sie schließlich progressiv abgekühlt wird mit einer Geschwindigkeit von etwa 20°C pro Stunde.

3. Verfahren nach Anspruch 1, dadurch gekennzeichnet, daß die Dauer, während der die Temperatur aufrecht erhalten wird, mindestens eine Stunde beträgt.

4. Verfahren nach einem der Ansprüche 1 bis 3, dadurch gekennzeichnet, daß die brutale Abschreckung der Ampulle nach dem Ausschalten der Heizeinrichtung des Behälters bewirkt wird, indem man ein kaltes Gas um die Ampulle herum zirkulieren läßt.

5. Verfahren nach Anspruch 4, dadurch gekennzeichnet, daß das Gas neutral ist und ausgewählt wird aus der Gruppe Helium, Argon und Stickstoff.

6. Verfahren nach Anspruch 4, dadurch gekennzeichnet, daß es sich bei dem Gas um trockenen Wasserstoff handelt.

7. Anwendung des Verfahrens nach einem der Ansprüche 1 bis 6 zur Herstellung einer polykristallinen Legierung, die ausgewählt wird aus der Gruppe, die umfaßt die ternären Legierungen $Cd_x Hg_{0,5-x} Te_{0,5}$ und die quaternären Legierungen $Cd_x Hg_{0,5-x} Te_y Se_{0,5-y}$, wobei in diesen Formeln bedeuten $0 < x < 0,5$ und $0 < y < 0,5$.